# EUROPEAN PATENT APPLICATION

(11) **EP 3 132 934 A1**
(43) Date of publication of application: **22.02.2017**
(21) Application number: 16184499.8
(22) Date of filing: 17.08.2016
(51) Int. Cl.: B41F 15/08, B41F 15/36, B41N 1/24, H05K 3/12

(54) **SQUEEGEE PRINTING ON DESCENDED SURFACES**

(30) Priority: 20.08.2015 US 201514830878
(71) Applicant: Sensata Technologies, Inc., Attleboro, MA 02703 (US)
(72) Inventor: PETRARCA, Neil S., Warwick, RI 02886 (US); ST. PIERRE, Keith D., Somerset, MA 02726 (US)
(74) Representative: Legg, Cyrus James Grahame

(57) **Abstract**

A stencil (300) for applying a viscous material (330) to a substrate (305) includes a substantially planar plate (315) affixed to the substrate (305), the plate (315) having at least one aperture (310) of a first dimension and at least one relief hole (322) of a second dimension, the at least one aperture (310) configured to align with a printing surface of the substrate (305) and the at least one relief hole (322) configured to align with a feature (312) having a height greater than the printing surface; and a mask (314) attached to a top surface of the plate (315) and positioned over the at least one relief hole (322) to protect the feature (312) having the height greater than the printing surface from a squeegee (325) applying the viscous material (330) over the plate (315).

## Description

### BACKGROUND OF THE INVENTION

The present invention generally relates to stencil printing, and more particularly to squeegee printing on descended surfaces.

One of the most important parts of a surface mount assembly process is the application of solder paste to a printed circuit board (PCB). One aim of this process is to accurately deposit the correct amount of solder paste onto each of the pads to be soldered. This is typically achieved by screen printing the solder paste through a stencil. It is widely believed that this part of the process, if not controlled correctly, accounts for the majority of assembly defects.

In general, stencil printing, also referred to a squeegee printing, is a process by which a viscous material is deposited through aperture openings of a stencil onto a substrate. The configuration of the stencil apertures determines the basic layout of the deposits.

In every squeegee printing application, a surface to be printed on must be the tallest surface because the process requires a bottom of the stencil to contact a top of the printing surface. If the printing surface is not the tallest surface, the bottom of the stencil will contact the tallest surface prior to reaching the printing surface, resulting in damage to the stencil.

### SUMMARY OF THE INVENTION

The following presents a simplified summary of the innovation described herein. This summary is not an extensive overview of the invention. It is intended to neither identify key nor critical elements of the invention nor delineate the scope of the invention. Its sole purpose is to present some concepts of the invention in a simplified form as a prelude to the more detailed description that is presented later.

The present invention generally relates to stencil printing, and more particularly to squeegee printing on descended surfaces.

In one aspect, the invention features a stencil for applying a viscous material to a substrate, the stencil including a substantially planar plate affixed to the substrate, the plate having at least one aperture of a first dimension and at least one relief hole of a second dimension, the at least one aperture configured to align with a printing surface of the substrate and the at least one relief hole configured to align with a feature having a height greater than the printing surface; and a mask attached to a top surface of the plate and positioned over the at least one relief hole to protect the feature having the height greater than the printing surface from a squeegee applying the viscous material over the plate.

In another aspect, the invention features a method including providing a substrate having at least one printing area and at least one feature with a height greater than the printing area, providing a stencil comprising an aperture configured to align with the printing area and a relief hole configured to align with the feature with a height greater than the printing area, securing the substrate to a positioning fixture, securing the stencil to the substrate, aligning the aperture with the printing area and the relief hole with the feature, and securing a mask over the feature in the relief hole.

These and other features and advantages will be apparent from a reading of the following detailed description and a review of the associated drawings. It is to be understood that both the foregoing general description and the following detailed description are explanatory only and are not restrictive of aspects as claimed.

### BRIEF DESCRIPTION OF THE DRAWINGS

The features and advantages of the invention are apparent from the following description taken in conjunction with the accompanying drawings in which:
FIG. 1 is a cross-section of a first exemplary stencil printing application.
FIG. 2 is a cross-section of a second exemplary stencil printing application.
FIG. 3 is a cross-section of a third exemplary stencil printing application.
FIG. 4 is an illustration of an exemplary notched squeegee.
FIG. 5 is a flow diagram.

### DETAILED DESCRIPTION OF THE INVENTION

The following detailed description of the invention references the accompanying drawings that illustrate specific embodiments in which the invention can be practiced. The embodiments are intended to describe aspects of the invention in sufficient detail to enable those skilled in the art to practice the invention. Other embodiments can be utilized and changes can be made without departing from the scope of the present invention. The following detailed description is, therefore, not to be taken in a limiting sense. The scope of the present invention is defined only by the appended claims, along with the full scope of equivalents to which such claims are entitled.

In this description, references to "one embodiment," "an embodiment," or "embodiments" mean that the feature or features being referred to are included in at least one embodiment of the technology. Separate references to "one embodiment," "an embodiment," or "embodiments" in this description do not necessarily refer to the same embodiment and are also not mutually exclusive unless so stated and/or except as will be readily apparent to those skilled in the art from the description. For example, a feature, structure, act, and so forth, described in one embodiment may also be included in other embodiments, but is not necessarily included. Thus, the present technology can include a variety of combinations and/or integrations of the embodiments described herein.

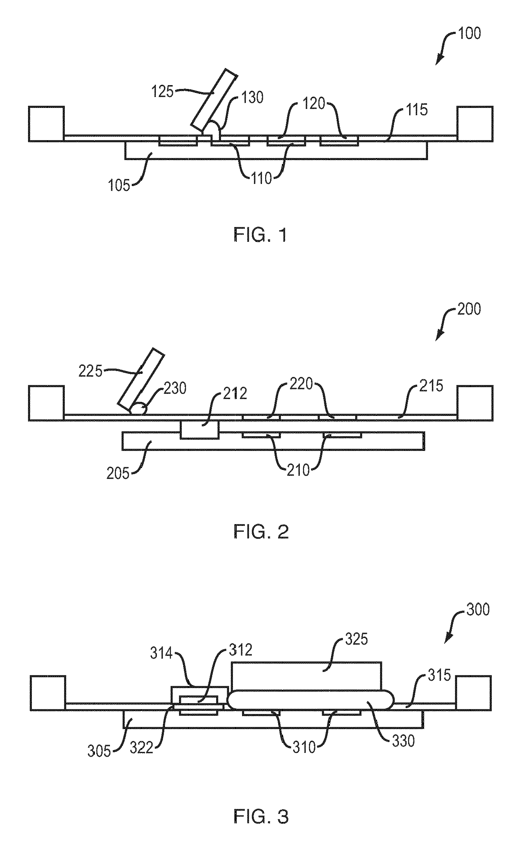

As shown in FIG. 1, a cross-section of an exemplary stencil printing application 100 includes a PCB 105. The PCB 105 includes one or more printing surfaces 110

(e.g., bond pads). A stencil 115 is secured to a top surface of the PCB 105. In general, stencils, such as stencil 115, can be manufactured from, for example, stainless steel or nickel. The stencil 115 includes apertures 120 designed to align with respective printing surfaces 110 on the PCB 105. In general, apertures, such as apertures 120, are formed in stencil 115 using, for example, laser cutting technology. A bottom of the stencil 115 contacts a top of the printing surfaces 110. An angled blade 125, referred to as a squeegee, is used to drive a viscous material 130 across a surface of the stencil 115 at a controlled speed and force.

In general, squeegees, such as squeegee 125, are manufactured from, for example, metal or plastic such as polyurethane. Example viscous materials include, but are not limited to, solder paste, glass paste, epoxy, conductive adhesives, such as silver paste, and so forth. As a result of the squeegee's 125 movement across the stencil 115, the apertures 120 on the stencil 115 are filled with the viscous material 130. When the stencil 115 is released from the printing surfaces 110 the resulting contents (i.e., the viscous material 130) of the filled apertures are transferred to the printing surfaces 110, thereby forming deposits.

In every squeegee printing application, such as application 100 described above, the printing surfaces 110 must always be the tallest surface on the PCB 105 because any squeegee printing application requires a bottom of the stencil 115 to contact the top of the printing surface(s) 110.

As shown in FIG. 2, a cross-section of an exemplary stencil printing application 200 includes a PCB 205. The PCB 205 includes one or more printing surfaces 210 (e.g., bond pads) and a tall component 212. A stencil 215 is secured to a top surface of the PCB 205. However, while the stencil 215 includes apertures 220 designed to align with respective printing surfaces 210 on the PCB 205, the tall component 212 prevents a bottom of the stencil 215 from contacting a top of the printing surfaces 210. Attempts to secure the stencil 210 to the PCB 205 can result in stencil 210 deformation. In addition, when an angled blade 225, referred to as a squeegee, is used to drive a viscous material 230 (e.g., solder paste, glass paste, epoxy, conductive adhesive, and so forth) across a surface of the stencil 215 at a controlled speed and force, the stencil 215 may also become deformed and/or the viscous material 230 entering the apertures 220 may flow uncontrollably across a top surface of the PCB 205.

As shown in FIG. 3, a cross-section of an exemplary stencil printing application 300 in accordance with the principles of the present invention includes a PCB 305. The PCB 305 includes one or more printing surfaces 310 (e.g., bond pads) and a tall component 312 (also referred to as a tall feature). A stencil 315 is secured to a top surface of the PCB 305. The stencil 315 includes apertures 320 designed to align with respective printing surfaces 310 on the PCB 305. The stencil 315 also includes a relief hole 322. Although in this representative cross-section only one relief hole 322 is shown, it should be appreciated that other examples may include multiple relief holes to match multiple tall features present on a PCB. The inclusion of a relief hole 322 enables a bottom of the stencil 315 to contact a top surface of the printing surfaces 310 by providing a pass through the stencil 315 for the tall component 312. More specifically, the relief hole 322 is cut in the stencil 315 in the same location and pitch as the tall component 312. An angled blade 325, referred to as a squeegee, is used to drive a viscous material 330 (e.g., solder paste, glass paste, epoxy, conductive adhesive, and so forth) across a surface of the stencil 315 at a controlled speed and force. Prior to initiating squeegee 325 movement, a cover or mask 314 is adhered to the top surface of stencil 315 to protect the tall component 312 from contact with the viscous material 330 or any other contamination. The mask 314 is configured with the same pitch as the tall feature 312. As a result of the squeegee's 325 movement across the stencil 315, the apertures 320 on the stencil 315 are filled with the viscous material 330. When the stencil 315 is released from the printing surfaces 310 the resulting contents (i.e., the viscous material 330) of the filled apertures are transferred to the printing surfaces 310, thereby forming deposits. Removing the stencil 315 also exposes the tall component 312. Thus, the configuration shown in FIG. 3 enables the printing to be performed on variable height surfaces.

In one embodiment, a blade of the squeegee 325 is relief cut to pass over and/or around the cover 314 on the top surface of the stencil 315.

In one example, the viscous material 330 is glass paste applied on an automotive sensor with a surface 310 that requires printing below one or more tall features 312.

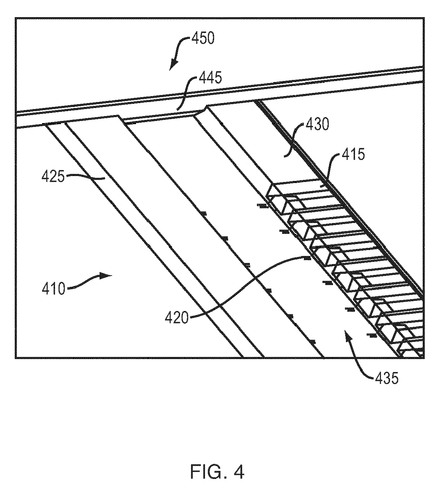

As shown in FIG. 4, during one exemplary manufacturing, a stencil 410 covers a number of automotive sensors (not shown) that are secured by a respective number of pairs of port flanges 415 to a tooling fixture (not shown). Printing patterns 420 (i.e., apertures) within the stencil 410 are aligned with respective printing surfaces on the PCBs. The stencil 410 includes relief holes (not shown) for each of the pairs of port flanges 415. Covers 425, 430 are adhered to a top surface of the stencil 410 and create a channel 435 for the viscous material to print. A blade 445 of the squeegee 450 is notched to print in the channel 435 without contacting the covers 425, 430. The blade 445 of the squeegee 450 travels inside the channel 435 created by the covers 425, 430, printing the pattern 420 on the ports below.

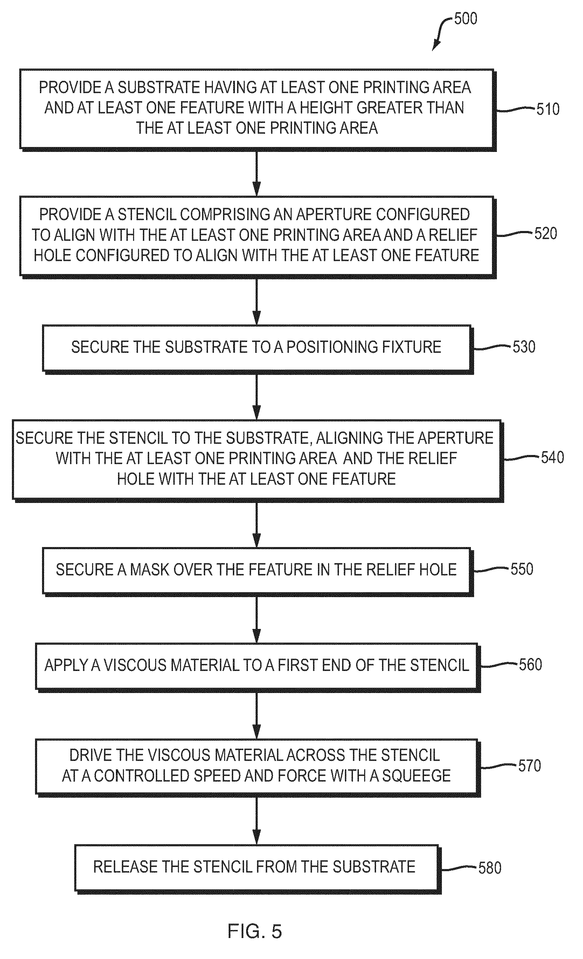

As shown in FIG. 5, a process 500 includes providing (510) a substrate having at least one printing area and at least one feature with a height greater than the at least one printing area.

Process 500 provides (520) a stencil comprising an aperture configured to align with the at least one printing area and a relief hole configured to align with the at least one feature.

Process 500 secures (530) the substrate to a positioning fixture.

Process 500 secures (540) the stencil to the substrate, aligning the aperture with the at least one printing area and the relief hole with the at least one feature.

Process 500 secures (550) a mask over the feature in the relief hole.

Process 500 applies (560) a viscous material to a first end of the stencil.

Process 500 drives (570) the viscous material across the stencil at a controlled speed and force with a squeegee.

Process 500 releases (580) the stencil from the substrate.

In summary, the present invention enables a printing to be performed on surfaces that are not the tallest surface. In a squeegee printing process where components or features prevent the bottom of the stencil from contacting the printing surface, the present invention uses relief holes cut in the stencil in the same location and pitch as the components or features. This allows the tallest components to pass through the stencil when the stencil is lowered to the printing surface.

Once the components or features pass through the stencil, they need to be protected during printing cycles from printing media contamination. This is accomplished by adhering a cover mask to the top side of the stencil around the perimeters of the relief hole cuts.

In some implementations, the squeegee blade is also relief cut to pass over or around the protective mask on the top surface of the stencil.

While the invention has been described with reference to exemplary embodiments, it will be understood by those skilled in the art that various changes may be made and equivalents may be substituted for elements thereof without departing from the scope of the invention. Accordingly, any apparently limiting statements are made only with regard to a particular embodiment, and are not limiting of the invention. In addition, many modifications will be appreciated by those skilled in the art to adapt a particular instrument, situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims.

## Claims

1. A stencil for applying a viscous material to a substrate, the stencil comprising:
a substantially planar plate affixed to the substrate, the plate having at least one aperture of a first dimension and at least one relief hole of a second dimension,
the at least one aperture configured to align with a printing surface of the substrate and the at least one relief hole configured to align with a feature having a height greater than the printing surface; and
a mask attached to a top surface of the plate and positioned over the at least one relief hole to protect the feature having the height greater than the printing surface from a squeegee applying the viscous material over the plate.

2. The stencil of claim 1 wherein the viscous material is selected from the group consisting of a solder paste, a glass paste, an epoxy and a conductive adhesive.

3. The stencil of claim 1 wherein the plate is constructed from materials selected from the group consisting of a stainless steel plate and a nickel plate.

4. The stencil of claim 1 wherein the mask is configured with a pitch matching the feature.

5. The stencil of claim 1 wherein the squeegee is an angled blade used to drive the viscous material across the top surface of the plate at a controlled speed and force.

6. The stencil of claim 1 wherein the squeegee comprises:
a body;
a handle on a proximal portion of the body; and
a blade on a distal portion of the body.

7. The stencil of claim 6 wherein the blade is notched to prevent blade contact with the mask.

8. A method comprising:
providing a substrate having at least one printing area and at least one feature with a height greater than the printing area;
providing a stencil comprising an aperture configured to align with the printing area and a relief hole configured to align with the feature with a height greater than the printing area;
securing the substrate to a positioning fixture;
securing the stencil to the substrate;
aligning the aperture with the printing area and the relief hole with the feature; and
securing a mask over the feature in the relief hole.

9. The method of claim 8 further comprising:
applying a viscous material to a first end of the stencil; and
driving the viscous material across the stencil at a controlled speed and force with a squeegee.

10. The method of claim 8 wherein the substrate is selected from the group consisting of a chip, a wafer and a Printed Circuit Board (PCB).

11. The method of claim 8 wherein the viscous material is selected from the group consisting of a solder paste, a glass paste, an epoxy and a conductive adhesive.

12. The method of claim 8 wherein the mask is configured with a pitch matching the at least one feature.

13. The stencil of claim 8 wherein the squeegee is an angled blade used to drive the viscous material across a top surface of the stencil at a controlled speed and force.

14. The method of claim 8 wherein the squeegee comprises:
a body;
a handle on a proximal portion of the body; and
a blade on a distal portion of the body.

15. The stencil of claim 14 wherein the blade is notched to prevent blade contact with the mask.
